# EUROPEAN PATENT APPLICATION

(11) **EP 4 734 681 A1**
(43) Date of publication of application: **29.04.2026**
(21) Application number: 24831947.7
(22) Date of filing: 25.06.2024
(51) Int. Cl.: H05K 7/20, H01L 23/34, H01L 23/36

(54) **HOUSING STRUCTURE AND METHOD FOR MANUFACTURING SAME**

(30) Priority: 26.06.2023 JP 2023104542
(71) Applicant: Sekisui Chemical Co., Ltd., Osaka-shi, Osaka 530-8565 (JP)
(72) Inventor: TATENO, Akihiko, Tokyo 105-8566 (JP)
(74) Representative: Ter Meer Steinmeister & Partner
(86) International application number: PCT/JP2024/023015
(87) International publication number: WO 2025/005087

(57) **Abstract**

Provided is a housing structure, which accommodates heat-generating components, that can effectively dissipate heat generated by the heat-generating components, is light in weight, and can be easily manufactured. The housing structure of the present invention includes a housing containing a heat-dissipating resin, and a heat-generating component accommodated in the housing. The housing has a partition wall portion that is integrally formed by resin molding on an inner surface thereof toward the heat-generating component and that is configured to surround the heat-generating component, and a part surrounded by the partition wall portion and the housing serves as a heat-generating component accommodation portion capable of accommodating the heat-generating component. A thermally conductive grease is interposed between opposed surfaces of the heat-generating component and the partition wall portion within the heat-generating component accommodation portion.

## Description

### Technical Field

The present invention relates to a housing structure and a method for manufacturing the same.

### Background Art

Conventionally, electrically powered vehicles using a motor as one of their drive sources, such as electric vehicles and hybrid vehicles, have been equipped with power conversion devices. Examples of the power conversion devices include chargers that convert commercially available alternating-current power into direct-current power and charge high-voltage batteries, DC/DC converters that convert direct-current power from high-voltage batteries into voltages for auxiliary device batteries, and inverters that convert direct-current power from batteries into alternating-current power for motors.

Power conversion devices used in electrically powered vehicles use many electronic components such as semiconductor switching elements, various resistors, aluminum electrolytic capacitors, reactors, and transformers. Many of these electronic components are heat-generating components that generate heat by themselves when conducting electricity. The heat generation by the heat-generating components turns the interior of the power conversion devices into high-temperature environments. Efficient dissipation of heat generated by the heat-generating components from the housings to the outside to cool the heat-generating components is thus demanded of the power conversion devices.

Patent Literature 1 discloses a power conversion device including a printed circuit board, an electromagnetic induction device that is electrically connected to the printed circuit board, a cooling unit that is opposed to the printed circuit board with the electromagnetic induction device therebetween and configured to cool the electromagnetic induction device, and a thermally conductive and electrically insulative case that has a U-shaped cross section and accommodates the electromagnetic induction device.

### Citation List

### Patent Literature

PTL 1: Japanese Patent Application Laid-Open No. 2015-089179

### Summary of Invention

### Technical Problem

The foregoing power conversion device includes the cooling unit and the thermally conductive and electrically insulative case that are separately formed. Grease serving as a heat-dissipating member is interposed between the cooling unit and the case, and the cooling unit, case, and grease have different coefficients of thermal expansion. Therefore, differences in the degree of expansion between the cooling unit, case, and grease lower the adhesion between these constituent members and create gaps when heat-generating components in the power conversion device generate heat. Moreover, thermal conductivity drops at the interfaces between adjacent components among the cooling unit, case, and grease. As a result, there is a problem that the heat generated by the heat-generating components is unable to be unimpededly transferred to the case and dissipated to the outside.

The case is disposed to be in contact with the printed circuit board via an adhesive, so that the heat generated by a heat-generating member is transferred to the printed circuit board through the case. This configuration results in a problem that circuits disposed on the printed circuit board may be adversely influenced by the heat.

In the foregoing power conversion device, the case needs to be disposed between the opposed surfaces of the cooling unit and the printed circuit board in a state where the case accommodating the heat-generating components within is connected to both the cooling unit and the printed circuit board. The power conversion device thus has problems of complicated manufacturing steps and low production efficiency.

Moreover, to dissipate the heat generated by the heat-generating components to the outside efficiently, the power conversion device to be mounted on electrically powered vehicles has a housing formed of metal with excellent thermal conductivity.

Since forming the housing of metal increases the weight of the power conversion device and causes a problem of worsening the fuel economy of an electrically powered vehicle equipped with the power conversion device, a weight reduction of the power conversion device is also demanded.

The present invention provides a housing structure, which accommodates heat-generating components, that can effectively dissipate heat generated by the heat-generating components, is light in weight, and can be easily manufactured.

### Solution To Problem

A housing structure of the present invention includes:
a housing containing a heat-dissipating resin;
a heat-generating component accommodated in the housing;
a partition wall portion that is integrally formed by resin molding on an inner surface of the housing, extends toward the heat-generating component. and is configured to surround the heat-generating component;
a heat-generating component accommodation portion that includes a part surrounded by the partition wall portion and the housing and is capable of accommodating the heat-generating component; and
a thermally conductive grease interposed between opposed surfaces of the heat-generating component and the partition wall portion within the heat-generating component accommodation portion.

A housing structure of the present invention includes:
a housing containing a heat-dissipating resin; and
a heat-generating component accommodated in the housing, wherein
the housing includes a partition wall portion that is integrally formed by resin molding on its inner surface, extends toward the heat-generating component, and is configured to surround the heat-generating component, and
a part surrounded by the partition wall portion and the housing is configured to serve as a heat-generating component accommodation portion capable of accommodating the heat-generating component, and a thermally conductive grease is interposed between opposed surfaces of the heat-generating component and the partition wall portion within the heat-generating component accommodation portion.

A method for manufacturing a housing structure of the present invention includes:
a heat-generating component disposing step of disposing and fixing a heat-generating component to a one-side housing, the one-side housing containing a heat-dissipating resin and having an opening;
a grease supplying step of supplying a thermally conductive grease having fluidity to a heat-generating component accommodation portion formed by a partition wall portion of an other-side housing and a part of the other-side housing surrounded by the partition wall portion, the other-side housing having an opening and containing a heat-dissipating resin, the partition wall portion being integrally formed by resin molding on an inner bottom surface of the other-side housing;
an embedding step of inserting the heat-generating component that has been disposed and fixed to the one-side housing into the heat-generating component accommodation portion of the other-side housing so that the heat-generating component of the one-side housing is embedded at least in part in the thermally conductive grease within the heat-generating component accommodation portion of the other-side housing; and
a thermally conductive grease fixing step of solidifying or curing the thermally conductive grease.

### Advantageous Effects of Invention

The housing structure of the present invention includes the partition wall portion that is integrally formed by resin molding on the inner surface of the housing, extends toward the heat-generating component, and surrounds the heat-generating component, and can effectively dissipate heat generated by the heat-generating component to the outside through the partition wall portion and the housing via the thermally conductive grease.

Since the housing structure includes the housing containing the heat-dissipating resin, unlike when a housing formed of metal is used, weight reduction of the housing structure can be achieved.

The housing and the partition wall portion are integrally constituted by resin molding without any connection interface. There is no reduction in thermal conductivity between the housing and the partition wall portion, and the heat generated by the heat-generating component can be transferred from the partition wall portion to the housing and unimpededly dissipated from the housing to the outside.

Moreover, since the housing and the partition wall portion have no connection interface at their junctions, the housing and the partition wall portion will not separate unexpectedly due to the heat generated by the heat-generating component. The housing and the partition wall portion remain constantly integrated, and the heat generated by the heat-generating component can be unimpededly transferred to the housing through the partition wall portion.

In the foregoing housing structure, the thermally conductive grease is interposed between the opposed surfaces of the heat-generating component and the housing opposed to the heat-generating component within the heat-generating component accommodation portion. The heat generated by the heat-generating component can thus be unimpededly transferred to the partition wall portion and the housing via the thermally conductive grease and released to the outside.

In the foregoing housing structure, when the heat-generating component is disposed on a printed circuit board, cooling measures for the heat-generating component can be easily implemented after disposing and fixing, in the housing, the heat-generating component that has been disposed on the printed circuit board.

In the foregoing housing structure, when a gap is formed between the partition wall portion and the printed circuit board opposed to the partition wall portion, the heat generated by a heat-generating member can be easily dissipated outside the partition accommodating the heat-generating member that is generating the heat, and the heat-generating member can be cooled without difficulty.

The formation of the gap between the partition wall portion and the printed circuit board can reduce the influence that the heat, which is being transferred from the heat-generating component to the partition wall portion, has on the printed circuit board, and the printed circuit board can be thermally protected.

Since the gap is formed between the partition wall portion and the printed circuit board, there is no need to provide a location on the printed circuit board for connecting the partition wall portion, and the printed circuit board can be reduced in size. Eliminating this necessity enables miniaturization of the housing structure.

In the foregoing housing structure, when heat dissipation fins are integrally formed by resin molding on the inner surface of the heat-generating component accommodation portion, the heat dissipation fins enable effective dissipation of the heat generated by the heat-generating component to the outside through the housing, and the cooling effect on the heat-generating component can be improved.

In the foregoing housing structure, when the thermally conductive grease is disposed between the heat dissipation fins, the contact area between the heat dissipation fins and the thermally conductive grease can be increased. The heat generated by the heat-generating component can be unimpededly dissipated to the outside through the housing, and the heat-generating component can be cooled without difficulty.

In the foregoing housing structure, the housing includes the one-side housing and the other-side housing that are split in two. When the housing is constituted by mating the opening of the one-side housing and the opening of the other-side housing, and the open end of the one-side housing and the open end of the other-side housing are integrated using an adhesive, weight reduction of the housing structure can be achieved.

The method for manufacturing a housing structure of the present invention includes the foregoing steps. The thermally conductive grease can thus be filled into a space between the opposed surfaces of at least part of the heat-generating component and the partition wall portion opposed thereto by the simple steps of: inserting the heat-generating component that has been disposed and fixed to the one-side housing into the thermally conductive grease having fluidity in the heat-generating component accommodation portion of the other-side housing so that the heat-generating component is embedded in the thermally conductive grease at least in part; and then solidifying or curing the thermally conductive grease. The heat generated by the heat-generating component can thus be released without difficulty to the outside through the thermally conductive grease and through the partition wall portion and the housing, and an excellent cooling effect on a heat-generating member can be provided.

When the foregoing method for manufacturing a housing structure includes an adhesion step of integrating the open end of the one-side housing and the open end of the other-side housing around the entire perimeter using an adhesive, the one-side housing and the other-side housing can be bonded and integrated by the adhesive. The resulting housing structure has excellent lightweight properties.

In the foregoing method for manufacturing a housing structure, when a mark for indicating the necessary amount of supply of the thermally conductive grease having fluidity is formed on the inner surface of the partition wall portion of the other-side housing, an appropriate amount of the thermally conductive grease can be supplied into the heat-generating component accommodation portion. The thermally conductive grease can thereby be reliably filled into a space between the opposed surfaces of at least part of the heat-generating component and the partition wall portion opposed thereto. The heat generated by the heat-generating component can thus be released more smoothly to the outside through the thermally conductive grease, partition wall portion, and housing, and an excellent cooling effect on the heat-generating member can be provided.

### Brief Description of Drawings

[Fig. 1] Fig. 1 is a sectional view showing a housing structure of the present invention.
[Fig. 2] Fig. 2 is a sectional view showing part of a manufacturing process of the housing structure of the present invention.
[Fig. 3] Fig. 3 is a perspective view showing an example of an other-side housing.
[Fig. 4] Fig. 4 is a sectional view showing another example of the housing structure.
[Fig. 5] Fig. 5 is a sectional view showing another example of the housing structure.
[Fig. 6] Fig. 6 is a sectional view showing another example of the housing structure.
[Fig. 7] Fig. 7 is a sectional view showing another example of the housing structure.
[Fig. 8] Fig. 8 is a sectional view showing another example of the housing structure.
[Fig. 9] Fig. 9 is a sectional view showing a housing structure serving as a comparative example.

### Description Of Embodiments

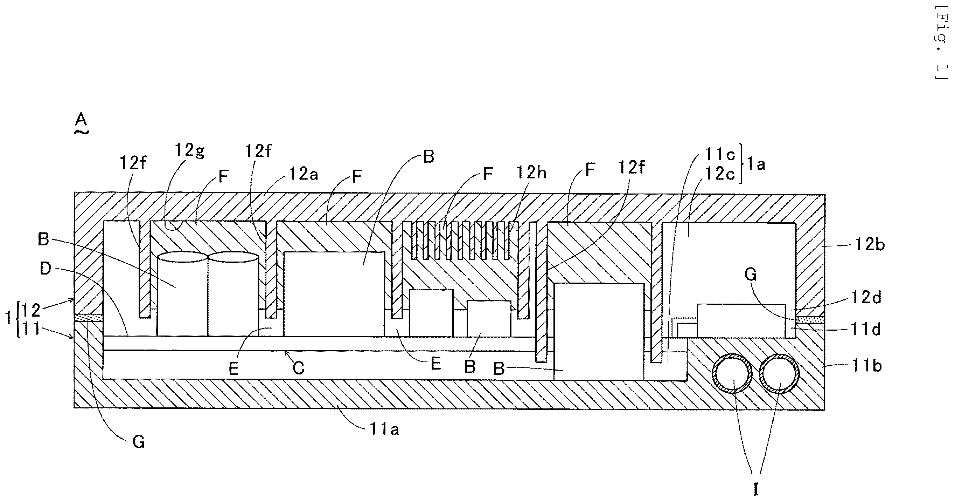

An example of a housing structure of the present invention will be described with reference to the drawings. As shown in Figs. 1 to 3, a housing structure A includes a housing 1. The housing 1 is configured as being split in two, and includes a one-side housing 11 and an other-side housing 12. The one-side housing 11 and the other-side housing 12 are manufactured by a general-purpose resin molding method such as injection molding and blow molding. The one-side housing 11 constituting the housing 1, partition wall portions and heat dissipation fins 12h and 12i to be described below, and the other-side housing 12 are formed of a heat-dissipating resin, whereby the housing 1 has excellent thermal conductivity. The heat-dissipating resin is constituted by incorporating into a synthetic resin a thermally conductive material having higher thermal conductivity than that of the synthetic resin. Examples of the thermally conductive material include thermally conductive particles such as graphite, graphite, carbon black, and metal fine particles, as well as thermally conductive fibers such as carbon fibers and metal fibers.

Either one or both of the one-side housing 11 and the other-side housing 12 are preferably manufactured by performing only once a resin molding step of thermally molding a raw material resin into a desired shape. Being manufactured through a single resin molding step, the one-side housing 11 and/or the other-side housing 12 can be formed as a molded article with no adhesive portion or thermally fused portion in its entire body and thus has excellent thermal conductivity.

The heat-dissipating resin preferably has a thermal conductivity of 2.0 W/m·K or higher, more preferably 4.0 W/m·K or higher, even more preferably 8.0 W/m·K or higher. The thermal conductivity of the heat-dissipating resin is preferably lower than or equal to 50.0 W/m·K. The thermal conductivity of the heat-dissipating resin is a value measured at 25°C on the basis of a laser flash method.

The one-side housing 11 includes a bottom portion 11a and a peripheral wall portion 11b that is integrally formed on the outer peripheral edge of the bottom portion 11a around the entire perimeter. The one-side housing 11 has a space portion 11c in the part surrounded by the bottom portion 11a and the peripheral wall portion 11b, where electronic components including heat-generating components B can be disposed. The space portion 11c has an opening 11d that is fully open.

The other-side housing 12 includes a bottom portion 12a and a peripheral wall portion 12b that is integrally formed on the outer peripheral edge of the bottom portion 12a around the entire perimeter. The other-side housing 12 has a space portion 12c in the part surrounded by the bottom portion 12a and the peripheral wall portion 12b, where electronic components including heat-generating components B can be disposed. The space portion 12c has an opening 12d that is fully open.

The opening 11d of the space portion 11c of the one-side housing 11 and the opening 12d of the space portion 12c of the other-side housing 12 are formed in the same shape. When the one-side housing 11 and the other-side housing 12 are stacked with the openings 11d and 12d of their space portions 11c and 12c opposed to each other, the frame-shaped edge of the peripheral wall portion 11b of the one-side housing 11 and the frame-shaped edge of the peripheral wall portion 12b of the other-side housing 12 match each other over the entire perimeter. The space portions 11c and 12c of the one-side housing 11 and the other-side housing 12 are thereby closed, and the space portions 11c and 12c of the one-side housing 11 and the other-side housing 12 form an electronic component accommodation portion 1a where electronic components can be accommodated. The frame-shaped edge of the peripheral wall portion 11b of the one-side housing 11 and the frame-shaped edge of the peripheral wall portion 12b of the other-side housing 12 are bonded and integrated via an adhesive G, whereby the housing structure has excellent lightweight properties. Coolant circulation paths I for circulating a coolant (such as water and air) for cooling the one-side housing 11 and/or the other-side housing 12 are formed in the one-side housing 11 and/or the other-side housing 12 as needed.

An electronic component C including heat-generating components B is disposed and fixed in the space portion 11c of the one-side housing 11. The heat-generating components B are components that generate heat through use. Examples include a reactor, a transformer, a coil, and a capacitor. The electronic component C may include a heat-generating component B alone, or may be a printed circuit board D on which heat-generating components B are disposed and fixed in an electrically connected state.

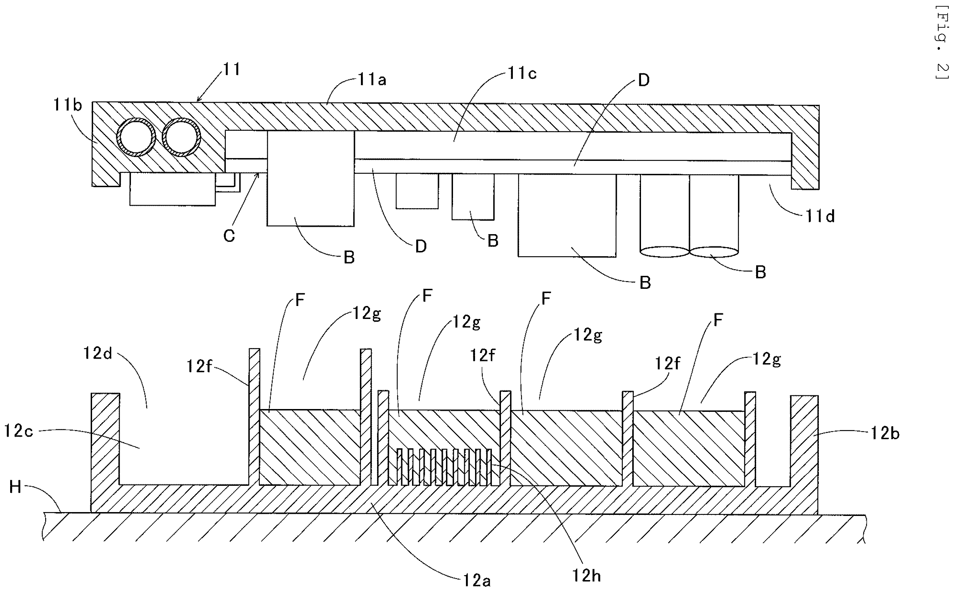

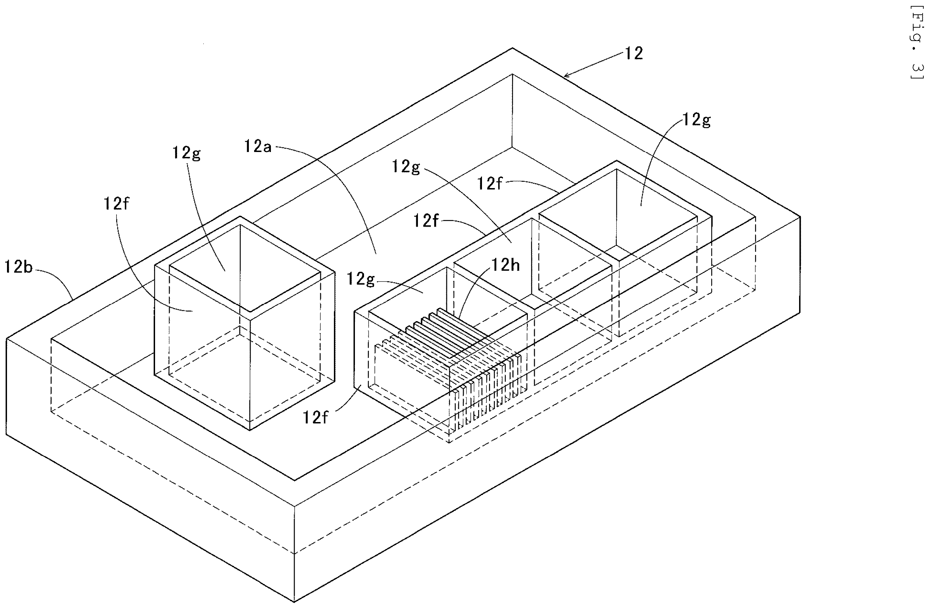

As shown in Figs. 2 and 3, one or more partition wall portions 12f are integrally protruded from the inner surface of the bottom portion 12a of the other-side housing 12. The partition wall portions 12f are protruded toward the heat-generating components B that have been disposed and fixed to the one-side housing 11 to surround the heat-generating components B in part or entirely. The partition wall portions 12f of the other-side housing 12 are protruded from the bottom portion 12a during resin molding of the other-side housing 12 and formed integrally with the bottom portion 12a without any connection interface between the partition wall portions 12f and the bottom portion 12a. When the housing structure is in use, the partition wall portions 12f and the bottom portion 12a therefore do not separate due to deformation or the like from the heat generated by the heat-generating components B. Moreover, when heat is conducted from the partition wall portions 12f to the bottom portion 12a, there is no reduction in thermal conductivity attributable to connection interfaces. The heat generated by the heat-generating components B can thus be unimpededly dissipated from the bottom portion 12a to the outside via the partition wall portions 12f. In the present invention, "there is no connection interface between two members" means that there is no adhesive portion or thermally fused portion at the interface of the two members when the two members are integrated. "There is no connection interface between the partition wall portions 12f and the bottom portion 12a" means that there is no adhesive portion or thermally fused portion at the interfaces between the partition wall portions 12f and the bottom portion 12a. The bottom portion 12a of the other-side housing 12 and the partition wall portions 12f integrated with the bottom portion 12a are preferably thermally molded at the same time by a resin molding step of thermally molding a raw material resin into a desired shape. For example, if the other-side housing 12 is molded by injection molding, the other-side housing 12 can be manufactured without any connection interface between the bottom portion 12a and the partition wall portions 12f by supplying the raw material resin into the cavity of the mold for molding the other-side housing 12, and thermally forming the bottom portion 12a of the other-side housing 12 and the partition wall portions 12f integrated with the bottom portion 12a at the same time.

The inner surfaces of the partition wall portions 12f of the other-side housing 12 and the inner surface of the bottom portion 12a surrounded by the partition wall portions 12f form heat-generating component accommodation portions 12g that are fully open at the end side and can accommodate the heat-generating components B in part or entirely. The heat-generating component accommodation portions 12g are formed to sizes capable of accommodating part or all of the heat-generating components B that have been disposed and fixed to the one-side housing 11. The shapes of the partition wall portions 12f are not limited in particular. The shapes of the partition wall portions 12f are appropriately adjusted to those of the heat-generating components B to accommodate. Examples include cylindrical shapes (rectangular cylindrical shapes and other prismatic shapes, as well as circular cylindrical shapes). Mutually adjacent partition wall portions 12f may be connected and integrated with each other by sharing part of the partition wall portions.

The heat-generating components B that have been disposed and fixed in the space portion 11c of the one-side housing 11 are accommodated in the heat-generating component accommodation portions 12g of the other-side housing 12 in part or entirely. One (one type of) heat-generating component B may be accommodated in one heat-generating component accommodation portion 12g. A plurality of (plurality of types of) heat-generating components B may be accommodated in one heat-generating component accommodation portion 12g.

Spaces formed between the heat-generating components B and the inner surfaces of the partition wall portions 12f and the inner surface of the bottom portion 12a of the other-side housing 12 opposed thereto are filled with a thermally conductive grease F in a solidified or cured solid state. The thermally conductive grease is constituted by incorporating thermally conductive fillers such as metal oxide powder, metal nitride powder, metal carbide powder, metal hydroxide powder, or the like into an uncured liquid matrix such as organopolysiloxane or poly-α-olefin. For applications where insulation properties are required, metal oxide powder, metal nitride powder, metal carbide powder, and metal hydroxide powder are preferably used as the thermally conductive fillers. Examples of the metal oxide include aluminum oxide, magnesium oxide, zinc oxide, and silicon oxide. Examples of the metal hydroxide include aluminum hydroxide and magnesium hydroxide. Examples of the metal nitride include aluminum nitride, silicon nitride, and boron nitride. Metal powders such as aluminum and copper powders, graphite, carbon fibers, and the like can also be used as heat conductive fillers. Curable thermally conductive greases are preferable because flow-out to the surroundings is prevented.

The thermally conductive grease preferably has a thermal conductivity of 2.0 W/m·K or higher, more preferably 3.0 W/m·K or higher, even more preferably 4.5 W/m·K or higher. The thermal conductivity of the thermally conductive grease is preferably lower than or equal to 40.0 W/m·K. The thermal conductivity of the thermally conductive grease is a value measured at 25°C on the basis of the laser flash method.

The spaces formed between the heat-generating components B and the inner surfaces of the partition wall portions 12f and the inner surface of the bottom portion 12a of the other-side housing 12 opposed to the heat-generating components B need not be entirely filled with the thermally conductive grease F. The spaces may be filled with the thermally conductive grease F only in part. However, the spaces formed between the heat-generating components B and the inner surface of the bottom portion 12a of the other-side housing 12 opposed thereto are preferably entirely filled with the thermally conductive grease F since the heat generated by the heat-generating components B can be directly transferred to the bottom portion 12a of the other-side housing 12 via the thermally conductive grease F and unimpededly dissipated to the outside.

The open ends of the partition wall portions 12f of the other-side housing 12 do not reach the base where the heat-generating components B are fixed, i.e., the bottom portion 11a of the one-side housing 11 or the printed circuit board D. There are gaps E between the open ends (extremities) of the partition wall portions 12f and the base (the bottom portion 11a of the one-side housing 11 or the printed circuit board D) opposed to the open ends (extremities).

The heat generated by a heat-generating component or components B accommodated in one heat-generating component accommodation portion 12g is dissipated to the outside through the bottom portion 12a of the other-side housing 12 via the thermally conductive grease F and the partition wall portions 12f constituting the heat-generating component accommodation portion 12g. Moreover, the heat flows outside one partition wall portion 12f through a gap E formed between the one partition wall portion 12f and the base, and is dissipated to the outside through the bottom portion 12a of the other-side housing 12 via other partition wall portions 12f disposed within the electronic component accommodation portion 1a of the housing 1. The heat generated by the heat-generating components B can thus be dissipated to the outside via a plurality of partition wall portions 12f, whereby the cooling effect on the heat-generating components B can be improved.

When heat-generating components B are disposed on the printed circuit board D, electrical circuits are formed on the printed circuit board D. The formation of the gaps E by preventing the extremities of the partition wall portions 12f from reaching the printed circuit board D can reduce the influence that the heat, which is being transferred to the partition wall portions 12f, has on the printed circuit board D, whereby the printed circuit board D can be prevented from being damaged by the heat generated by the heat-generating components B.

Since the partition wall portions 12f are not in contact with the printed circuit board D, there is no need to provide areas on the printed circuit board D for the partition wall portions 12f to come into contact with. The printed circuit board D can be miniaturized by eliminating unnecessary areas from the printed circuit board D, and by extension size and weight reduction of the housing structure A can be achieved.

A plurality of heat dissipation fins 12h are preferably integrally protruded from the inner surface of a part of the bottom portion 12a surrounded by the inner surfaces of partition wall portions 12f of the other-side housing 12, toward the interior of the heat-generating component accommodation portion 12g. The heat dissipation fins 12h need not be integrally protruded from the inner surfaces of all the parts of the bottom portion 12a surrounded by the inner surfaces of the partition wall portions 12f in the other-side housing 12. The heat dissipation fins 12h may be integrally protruded partly. The heat dissipation fins 12h are protruded from the inner surface of the bottom portion 12a during resin molding of the other-side housing 12 and formed integrally with the bottom portion 12a without any connection interface between the heat dissipation fins 12h and the bottom portion 12a. The heat dissipation fins 12h are formed of the heat-dissipating resin. The thermally conductive grease F is also filled into spaces between the opposed surfaces of the plurality of heat dissipation fins 12h. When the housing structure A is in use, the heat dissipation fins 12h and the bottom portion 12a therefore do not separate due to deformation or the like from the heat generated by the heat-generating components B. Moreover, when heat is conducted from the heat dissipation fins 12h to the bottom portion 12a, there is no reduction in thermal conductivity attributable to connection interfaces. The heat generated by the heat-generating components B can thus be unimpededly dissipated from the bottom portion 12a to the outside via the heat dissipation fins 12h and the thermally conductive grease F. "There is no connection interface between the heat dissipation fins 12h and the bottom portion 12a" means that there is no adhesive portion or thermally fused portion at the interfaces between the heat dissipation fins 12h and the bottom portion 12a. The bottom portion 12a of the other-side housing 12 and the heat dissipation fins 12h integrated with the bottom portion 12a are preferably thermally molded at the same time through a resin molding step of thermally molding a raw material resin into a desired shape. For example, if the other-side housing 12 is molded by injection molding, the other-side housing 12 can be manufactured without any connection interface between the bottom portion 12a and the heat dissipation fins 12h by supplying the raw material resin into the cavity of the mold for molding the other-side housing 12 and thermally forming the bottom portion 12a of the other-side housing 12 and the heat dissipation fins 12h integrated with the bottom portion 12a at the same time.

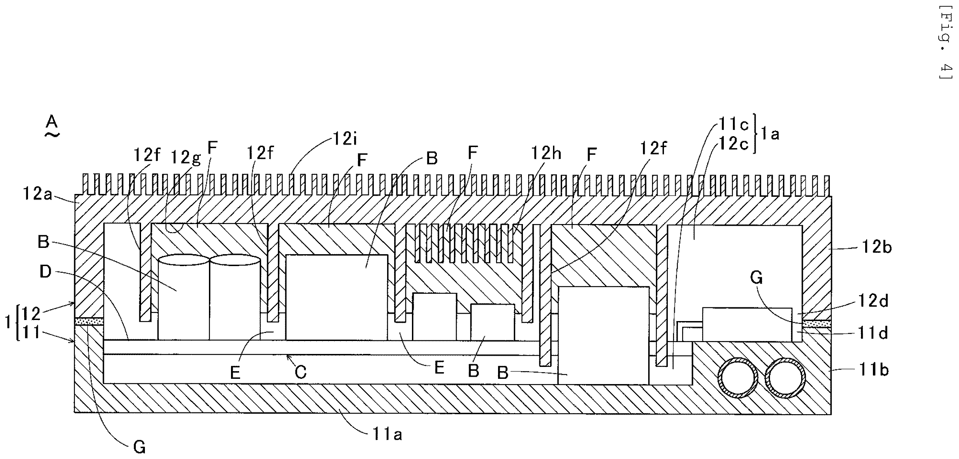

As shown in Fig. 4, a plurality of heat dissipation fins 12i may also be integrally protruded from the outer surface of the housing 1 (preferably, the outer surface of the other-side housing 12). The heat dissipation fins 12i are protruded from the outer surface of the housing 1 (preferably, the bottom portion 12a of the other-side housing 12) during the resin molding of the housing 1 (preferably, the other-side housing 12). The heat dissipation fins 12i are integrally formed on the housing 1 (preferably, the bottom portion 12a of the other-side housing 12) without any connection interface between the heat dissipation fins 12i and the housing 1 (preferably, the bottom portion 12a of the other-side housing 12). The heat dissipation fins 12i are formed of the heat-dissipating resin. When the housing structure A is in use, the heat dissipation fins 12i and the housing 1 therefore do not separate due to deformation or the like from the heat generated by the heat-generating components B. Moreover, when heat is conducted from the heat dissipation fins 12i to the housing 1, there is no reduction in thermal conductivity attributable to connection interfaces. The heat generated by the heat-generating components B can thus be more effectively dissipated to the outside from the heat dissipation fins 12i. "There is no connection interface between the heat dissipation fins 12i and the housing 1" means that there is no adhesive portion or thermally fused portion at the interfaces of the heat dissipation fins 12i and the housing 1. The housing 1 and the heat dissipation fins 12i integrated with the housing 1 are preferably thermally molded at the same time by a resin molding step of thermally molding the raw material resin into a desired shape. For example, if the housing 1 is molded by injection molding, the housing 1 can be manufactured without any connection interface between the housing 1 and the heat dissipation fins 12i by supplying the raw material resin into the cavity of the mold for molding the housing 1 and thermally forming the housing 1 and the heat dissipation fins 12i integrated with the housing 1 at the same time.

Some of the heat dissipation fins 12i formed on the outer surface of the housing 1 are preferably formed on the outer surface of the other-side housing 12 or the outer surface of the bottom portion 12a opposite to the partition wall portions 12f across the other-side housing 12 or the bottom portion 12a thereof. The heat dissipation fins 12i are preferably formed at portions where the partition wall portions 12f are projected upon the outer surface of the housing 1 in the direction opposite to the formation direction of the partition wall portions 12f. The heat generated by the heat-generating components B can be efficiently dissipated outside the housing 1 via the partition wall portions 12f and the heat dissipation fins 12i.

Next, a method for manufacturing the housing structure will be described. The electronic component C including the heat-generating components B is disposed and fixed in the space portion 11c of the one-side housing 11 by using a general-purpose procedure (heat-generating component disposing step).

Meanwhile, as shown in Fig. 2, the other-side housing 12 is placed on a given placement surface H with the heat-generating component accommodation portions 12g, which are formed by being surrounded by the partition wall portions 12f, open upward. The thermally conductive grease F having fluidity is supplied into the heat-generating component accommodation portions 12g of the other-side housing 12. If the thermally conductive grease F is solid under normal conditions, the thermally conductive grease F needs to be heated to be fluid. On the inner surfaces of the partition wall portions 12f of the other-side housing 12, a mark with a scale, a step, or the like is formed to indicate the necessary amounts of supply of the thermally conductive grease F. The thermally conductive grease F having fluidity is supplied into the heat-generating component accommodation portions 12g up to the necessary amounts of supply indicated by the marks (grease supplying step).

Next, as shown in Fig. 2, the one-side housing 11 is inverted upside down so that the opening 11d of the space portion 11c of the one-side housing 11 is opposed to the opening 12d of the space portion 12c of the other-side housing 12. The heat-generating components B on the one-side housing 11 to be embedded into the thermally conductive grease F in the heat-generating component accommodation portions 12g are then located above the respective heat-generating component accommodation portions 12g of the other-side housing 12.

The one-side housing 11 is then moved in the direction of bringing the-side housing 11 close to the other-side housing 12 (downward) so that the frame-shaped edge of the peripheral wall portion 11b of the one-side housing 11 and the frame-shaped edge of the peripheral wall portion 12b of the other-side housing 12 match around the entire perimeter. The heat-generating components B fixed to the one-side housing 11 are embedded in part or entirely into the thermally conductive grease F in the respective heat-generating component accommodation portions 12g of the other-side housing 12 (embedding step). This step can be performed by a simple procedure since the heat-generating components B are inserted from above and embedded into the thermally conductive grease F held in the respective heat-generating component accommodation portions 12g of the other-side housing 12. Moreover, the spaces formed between at least the extremities of the heat-generating components B and the partition wall portions 12f and bottom portion 12a opposed thereto can be filled up with the thermally conductive grease F. The heat generated by the heat-generating components B can thereby be efficiently guided to the partition wall portions 12f and bottom portion 12a via the thermally conductive grease F and dissipated to the outside.

The one-side housing 11 and the other-side housing 12 are integrated using the adhesive G, with the adhesive G interposed entirely between the frame-shaped edge of the peripheral wall portion 11b of the one-side housing 11 and the frame-shaped edge of the peripheral wall portion 12b of the other-side housing 12. In this state, the space portions 11c and 12c of the one-side housing 11 and the other-side housing 12 form the electronic component accommodation portion 1a. The electronic component C including the heat-generating components B is accommodated in this electronic component accommodation portion 1a.

Then, the thermally conductive grease F in the respective heat-generating component accommodation portions 12g of the other-side housing 12 is cooled, solidified, or cured to lose its fluidity and become solid (thermally conductive grease fixing step), whereby the housing structure A is manufactured by fixing the heat-generating components B as embedded in the thermally conductive grease F in part or entirely.

As described above, the housing structure A can be easily manufactured through the simple procedure of supplying the thermally conductive grease F having fluidity into the respective heat-generating component accommodation portions 12g of the other-side housing 12 and embedding, in the thermally conductive grease F, part or all of the heat-generating components B that have been disposed and fixed to the one-side housing 11 from above.

When the housing structure A is in use, the heat-generating components B accommodated in the electronic component accommodation portion 1a generate heat. This heat is unimpededly dissipated to the outside through the bottom portion 12a of the other-side housing 12 formed of the heat-dissipating resin via the thermally conductive grease F and/or the partition wall portions 12f (and heat dissipation fins 12i and 12h) formed of the heat-dissipating resin. The electronic component C is thereby efficiently cooled.

As described above, the housing structure A can unimpededly dissipate the heat generated by the heat-generating components B to the outside of the housing 1, thermally protect the electronic component C disposed in the housing 1, and enable stable operation of the electronic component C. Thanks to the excellent lightweight properties, the housing structure A can be mounted on electric vehicles etc., with power conversion devices and the like accommodated therein.

### [Examples]

Hereinafter, the present invention will be described more specifically using specific examples, but the invention is not limited thereto. In the following description, specific numerical values for composition percentage (content percentage), physical property values, parameters, and the like, may be substituted for upper limit values (numerical values defined as "less than or equal to" or "less than") or lower limit values (numerical values defined as "greater than or equal to" or "greater than") of the corresponding composition percentage (content percentage), physical property values, parameters, and the like, as described in the section "Description of Embodiments".

### (Example 1)

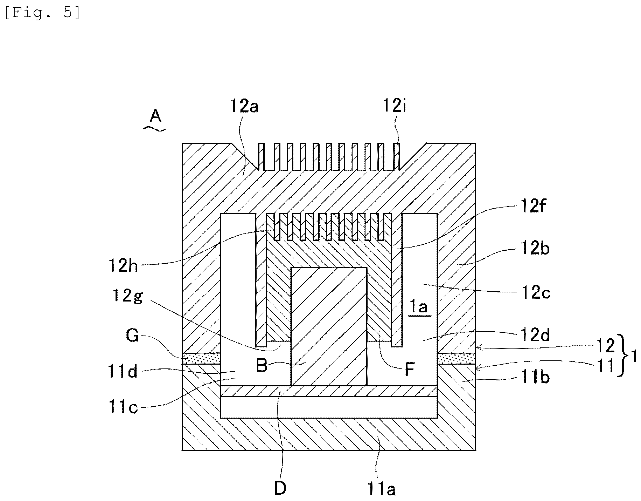

As shown in Fig. 5, a one-side housing 11 including a bottom portion 11a and a peripheral wall portion 11b integrally formed on the outer peripheral edge of this bottom portion 11a around the entire perimeter was prepared. The one-side housing 11 had a space portion 11c in a part surrounded by the bottom portion 11a and the peripheral wall portion 11b, where an electronic component including heat-generating components B could be disposed and that had a fully open opening 11d. The one-side housing 11 was formed of a heat-dissipating resin (thermal conductivity: 12.3 W/m·K) containing 100 parts by mass of polypropylene (product name "BC10HRF" manufactured by Japan Polypropylene Corporation), 100 parts by mass of expanded graphite (product name "EXP-80S220" manufactured by Fuji Graphite Works Co., Ltd., expansion ratio: 200 mL/g, volume average particle diameter: 180 µm), and 100 parts by mass of flaky graphite (product name "CPB-100" manufactured by Chuetsu Graphite Works Co., Ltd., volume average particle diameter: 100 µm).

An other-side housing 12 including a bottom portion 12a and a peripheral wall portion 12b integrally formed on the outer peripheral edge of this bottom portion 12a around the entire perimeter was prepared. The other-side housing 12 had a space portion 12c in a part surrounded by the bottom portion 12a and the peripheral wall portion 12b, where an electronic component including heat-generating components B could be disposed and that had a fully open opening 12d. The other-side housing 12 was composed of the same heat-dissipating resin as that of the one-side housing 11.

When the one-side housing 11 and the other-side housing 12 were stacked with the openings 11d and 12d of their space portions 11c and 12c opposed to each other, the space portions 11c and 12c of the one-side housing 11 and the other-side housing 12 were closed, and the space portions 11c and 12c of the one-side housing 11 and the other-side housing 12 formed an electronic component accommodation portion 1a capable of accommodating electronic components. The frame-shaped edge of the peripheral wall portion 11b of the one-side housing 11 and the frame-shaped edge of the peripheral wall portion 12b of the other-side housing 12 were bonded and integrated via an adhesive G. A housing 1 was constituted by the one-side housing 11 and the other-side housing 12.

A heat-generating component B was disposed and fixed in the space portion 11c of the one-side housing 11. The heat-generating component B was fixed on a printed circuit board D. One cylindrical partition wall portion 12f to surround part of the heat-generating component B was integrally protruded from the inner surface of the bottom portion 12a of the other-side housing 12 toward the heat-generating component B that had been disposed and fixed to the one-side housing 11. The partition wall portion 12f of the other-side housing 12 was protruded from the bottom portion 12a during resin molding of the other-side housing 12 and formed integrally with the bottom portion 12a without any connection interface between the partition wall portion 12f and the bottom portion 12a. The partition wall portion 12f was composed of the same heat-dissipating resin as that of the one-side housing 11.

The inner surface of the partition wall portion 12f of the other-side housing 12 and the inner surface of the bottom portion 12a surrounded by this partition wall portion 12f formed a heat-generating component accommodation portion 12g that had a fully open extremity and was capable of accommodating the heat-generating component B in part or entirely. The heat-generating component B that had been disposed and fixed in the space portion 11c of the one-side housing 11 was accommodated in part or entirely in the heat-generating component accommodation portion 12g of the other-side housing 12.

A plurality of heat dissipation fins 12h were integrally protruded toward the interior of the heat-generating component accommodation portion 12g from the inner surface of the bottom portion 12a surrounded by the inner surface of the partition wall portion 12f of the other-side housing 12. The heat dissipation fins 12h were composed of the same heat-dissipating resin as that of the one-side housing 11. There was no connection interface between the heat dissipation fins 12h and the bottom portion 12a. The heat dissipation fins 12h were composed of the same heat-dissipating resin as that of the other-side housing 12.

Moreover, a plurality of heat dissipation fins 12i were integrally protruded from the outer surface of the other-side housing 12. The heat dissipation fins 12i were protruded from the outer surface of the bottom portion 12a during resin molding of the other-side housing 12 and formed integrally with the bottom portion 12a without any connection interface between the heat dissipation fins 12i and the bottom portion 12a. The heat dissipation fins 12i were composed of the same heat-dissipating resin as that of the other-side housing 12. Some of the heat dissipation fins 12i were formed on the outer surface of the bottom portion 12a opposed to the partition wall portion 12f across the bottom portion 12a of the other-side housing 12. Specifically, some of the heat dissipation fins 12i were formed at portions where the partition wall portion 12f was projected upon the outer surface of the housing 1 in a direction (in Fig. 5, upward) opposite to the formation direction of the partition wall portion 12f.

A space formed between the heat-generating component B and the inner surfaces of the partition wall portion 12f and the bottom portion 12a of the other-side housing 12 opposed thereto was filled with a thermally conductive grease F (thermal conductivity: 6 W/m.K). The open end of the partition wall portion 12f of the other-side housing 12 did not reach the printed circuit board D on which the heat-generating component B was fixed.

The heat-generating component B of the housing structure A (Fig. 5) configured as described above was driven. The surface of the heat-generating component B was measured for temperature T after a lapse of 10 minutes from the driving of the heat-generating component B. Table 1 shows the temperature T.

### (Example 2)

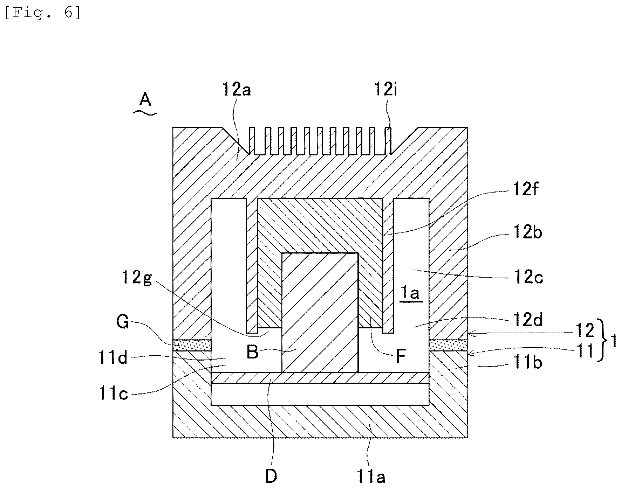

A housing structure A (Fig. 6) having the same structure as the housing structure of example 1 was prepared, except that the heat dissipation fins 12h were not formed on the inner surface of the bottom portion 12a of the other-side housing 12 and the inner surface of the bottom portion 12a was formed as a smooth surface. The heat-generating component B of the housing structure A was driven. The surface of the heat-generating component B was measured for temperature T after a lapse of 10 minutes from the driving of the heat-generating component B. Table 1 shows the temperature T.

### (Example 3)

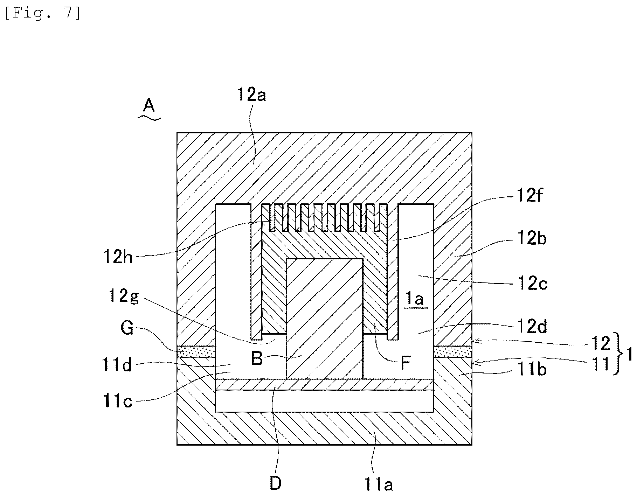

A housing structure A (Fig. 7) having the same structure as the housing structure of example 1 was prepared, except that the heat dissipation fins 12i were not formed on the outer surface of the bottom portion 12a of the other-side housing 12 and the outer surface of the bottom portion 12a was formed as a flat surface. The heat-generating component B of the housing structure A was driven. The surface of the heat-generating component B was measured for temperature T after a lapse of 10 minutes from the driving of the heat-generating component B. Table 1 shows the temperature T.

### (Example 4)

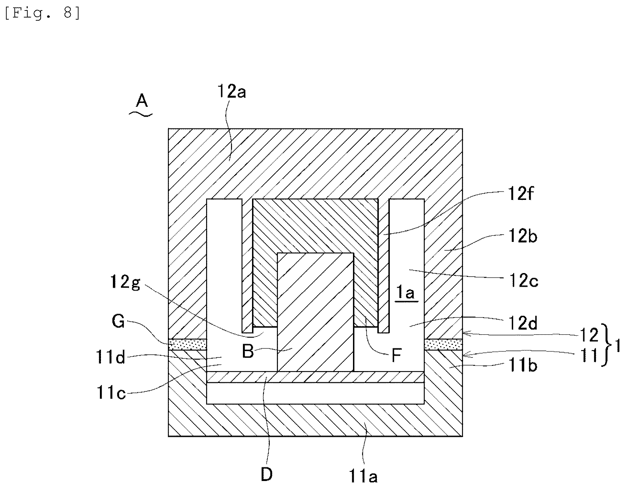

A housing structure A (Fig. 8) having the same structure as the housing structure of example 1 was prepared, except that the heat dissipation fins 12h and 12i were not formed on the inner and outer surfaces of the bottom portion 12a of the other-side housing 12 and the inner and outer surfaces of the bottom portion 12a were formed as flat surfaces. The heat-generating component B of the housing structure A was driven. The surface of the heat-generating component B was measured for temperature T after a lapse of 10 minutes from the driving of the heat-generating component B. Table 1 shows the temperature T.

### (Comparative Example 1)

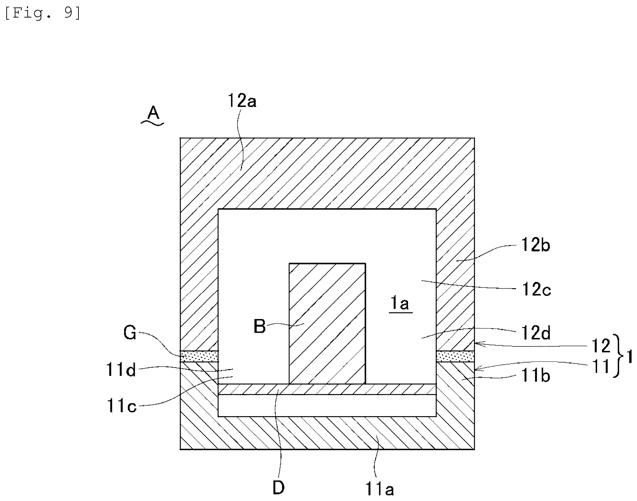

A housing structure A (Fig. 9) having the same structure as the housing structure of example 4 was prepared, except that no partition wall portion was formed on the inner surface of the bottom portion 12a of the other-side housing 12 and no thermally conductive grease was used. An air layer was formed in the space formed between the inner surface of the housing 1 and the heat-generating component B, and the housing 1 and the heat-generating component B were not in contact with each other. The heat-generating component B of the housing structure A was driven. The surface of the heat-generating component B was measured for temperature T after a lapse of 10 minutes from the driving of the heat-generating component B. Table 1 shows the temperature T.

**[Table 1]**

| | Example 1 | Example 2 | Example 3 | Example 4 | Comparative Example 1 |
|---|---|---|---|---|---|
| Temperature T (°C) | 90.5 | 92.5 | 99.7 | 105.8 | 152.5 |

### (Cross-reference to related application)

The present application claims the priority under Japanese Patent Application No. 2023-104542, filed on June 26, 2023, the disclosure of which is herein incorporated in its entirety by reference.

### Industrial applicability

According to the housing structure of the present invention, heat generated by heat-generating components can be effectively dissipated to the outside through the partition wall portion and the housing via the thermally conductive grease, and the housing structure has excellent lightweight properties. Thus, the housing structure is suitable for use in power conversion devices used in electrically powered vehicles, for example.

### Reference Signs List

- 1: housing
- 1a: electronic component accommodation portion
- 11: one-side housing
- 11a: bottom portion
- 11b: peripheral wall portion
- 11c: space portion
- 11d: opening
- 12: other-side housing
- 12a: bottom portion
- 12b: peripheral wall portion
- 12c: space portion
- 12d: opening
- 12f: partition wall portion
- 12g: heat-generating component accommodation portion
- 12h: heat dissipation fin
- A: housing structure
- B: heat-generating component
- C: electronic component
- D: printed circuit board
- E: gap
- F: thermally conductive grease
- G: adhesive

## Claims

1. A housing structure comprising:
a housing containing a heat-dissipating resin;
a heat-generating component accommodated in the housing;
a partition wall portion that is integrally formed by resin molding on an inner surface of the housing, extends toward the heat-generating component, and is configured to surround the heat-generating component;
a heat-generating component accommodation portion that includes a part surrounded by the partition wall portion and the housing and is capable of accommodating the heat-generating component; and
a thermally conductive grease interposed between opposed surfaces of the heat-generating component and the partition wall portion within the heat-generating component accommodation portion.

2. The housing structure according to claim 1, wherein the thermally conductive grease is interposed between opposed surfaces of the heat-generating component and the housing opposed to the heat-generating component within the heat-generating component accommodation portion.

3. The housing structure according to claim 1 or 2, wherein a heat-generating member is disposed on a printed circuit board.

4. The housing structure according to claim 3, wherein a gap is formed between the partition wall portion and the printed circuit board opposed to the partition wall portion.

5. The housing structure according to claim 1 or 2, wherein heat dissipation fins are integrally formed by resin molding on the inner surface of the heat-generating component accommodation portion.

6. The housing structure according to claim 5, wherein the thermally conductive grease is disposed between the heat dissipation fins.

7. The housing structure according to claim 1, wherein the housing includes a one-side housing and an other-side housing that are split in two, the housing is constituted by mating an opening of the one-side housing and an opening of the other-side housing and integrating them, and an open end of the one-side housing and an open end of the other-side housing are integrated by an adhesive.

8. The housing structure according to claim 1 or 2, wherein the heat-generating component is at least one heat-generating component selected from the group consisting of a reactor, a transformer, a coil, and a capacitor.

9. The housing structure according to claim 1 or 2, wherein heat dissipation fins are formed on a portion of an outer surface of the housing on which the partition wall portion is projected on a side opposite to a formation direction of the partition wall portion.

10. A method for manufacturing a housing structure, comprising:
a heat-generating component disposing step of disposing and fixing a heat-generating component to a one-side housing, the one-side housing containing a heat-dissipating resin and having an opening;
a grease supplying step of supplying a thermally conductive grease having fluidity into a heat-generating component accommodation portion formed by a partition wall portion of an other-side housing and a part of the other-side housing surrounded by the partition wall portion, the other-side housing having an opening and containing a heat-dissipating resin, the partition wall portion being integrally formed by resin molding on an inner bottom surface of the other-side housing;
an embedding step of inserting the heat-generating component that has been disposed and fixed to the one-side housing into the heat-generating component accommodation portion of the other-side housing and embedding the heat-generating component of the one-side housing at least in part in the thermally conductive grease within the heat-generating component accommodation portion of the other-side housing; and
a thermally conductive grease fixing step of solidifying or curing the thermally conductive grease.

11. The method for manufacturing a housing structure according to claim 10, wherein heat dissipation fins are integrally formed by resin molding on the inner surface of the heat-generating component accommodation portion.

12. The method for manufacturing a housing structure according to claim 10 or 11, wherein
the embedding step includes:
a placing step of placing the other-side housing on a placement surface with an opening of the heat-generating component accommodation portion open upward;
a step of disposing the heat-generating component disposed in the one-side housing above the other-side housing so that the heat-generating component is opposed to the opening of the heat-generating component accommodation portion of the other-side housing; and
a step of bringing the one-side housing and the other-side housing close to each other, inserting the heat-generating component that has been disposed and fixed to the one-side housing into the heat-generating component accommodation portion of the other-side housing, and embedding at least a part of the heat-generating component in the one-side housing in the thermally conductive grease within the heat-generating component accommodation portion of the other-side housing.

13. The method for manufacturing a housing structure according to claim 10 or 11, comprising an adhesion step of integrating an open end of the one-side housing and an open end of the other-side housing across an entire perimeter using an adhesive.

14. The method for manufacturing a housing structure according to claim 10 or 11, wherein a mark for indicating a necessary amount of supply of the thermally conductive grease having fluidity is formed on an inner surface of the partition wall portion of the other-side housing.

15. The method for manufacturing a housing structure according to claim 14, wherein the mark is a scale or a step provided on the inner surface of the partition wall portion.
